# EUROPEAN PATENT APPLICATION

(11) **EP 4 382 924 A1**
(43) Date of publication of application: **12.06.2024**
(21) Application number: 22937770.0
(22) Date of filing: 19.04.2022
(51) Int. Cl.: G01R 31/00, G01R 31/36, G01R 31/367, G01R 31/385, H01M 10/44, H01M 10/48, G01N 27/00, B07C 5/344

(54) **ABNORMAL BATTERY CELL IDENTIFICATION METHOD AND APPARATUS, ELECTRONIC DEVICE, AND STORAGE MEDIUM**

(71) Applicant: Contemporary Amperex Technology Co., Limited, Ningde, Fujian 352100 (CN)
(72) Inventor: FAN, Xiaoyun, Ningde, Fujian 352100 (CN); SUN, Jianan, Ningde, Fujian 352100 (CN); LIN, Deming, Ningde, Fujian 352100 (CN); WU, Jingliang, Ningde, Fujian 352100 (CN)
(74) Representative: Ran, Handong
(86) International application number: PCT/CN2022/087737
(87) International publication number: WO 2023/201532

(57) **Abstract**

An abnormal battery cell identification method and apparatus, an electronic device, and a storage medium. The identification method comprises: determining, on the basis of target feature data of a battery cell (11), whether or not the battery cell (11) has experienced a polarization abnormality, wherein the target feature data comprises feature data generated during battery cell formation and relating to battery cell polarization. On the one hand, since target feature data of a battery cell having abnormal polarization is distinctively different from target feature data of a battery cell without abnormal polarization during battery cell formation, it is possible to accurately determine whether or not the battery cell has experienced a polarization abnormality. On the other hand, since battery cell formation takes place before battery cells are assembled into a battery pack, a battery cell having abnormal polarization can be identified before the assembly, thereby reducing the risk of battery system performance deterioration and battery pack scrapping resulting from installing an abnormal battery cell.

## Description

### TECHNICAL FIELD

This application relates to the field of batteries, and specifically to a method and apparatus for identifying abnormal battery cell, an electronic device, and a storage medium.

### BACKGROUND

Formation of lithium-ion batteries is a critical step in battery production. The results of formation directly affect the cycle life, rate performance, high- and low-temperature performance, and other characteristics of batteries. Under a condition that battery cells have experienced abnormal polarization during the battery production process, no issues are apparent during the testing stage on the production line. However, after use (cycling), lithium precipitation and low capacity issues may occur in batteries. Loading of these abnormal battery cells affects the performance of the battery system, and as the integration level of the battery system increases, removal of abnormal battery cells becomes increasingly difficult. Loading of abnormal battery cells may result in an entire battery pack loaded with the abnormal battery cells being scrapped. Therefore, it is necessary to identify battery cells with abnormal polarization before the battery cells are loaded.

### SUMMARY

The purpose of embodiments of this application is to provide a method and apparatus for identifying abnormal battery cell, an electronic device, and a storage medium, so as to identify a battery cell with abnormal polarization before the battery cell is loaded.

According to a first aspect, an embodiment of this application provides a method for identifying abnormal battery cell, including determining, based on target feature data of a battery cell, whether the battery cell has experienced abnormal polarization; where the target feature data includes feature data related to polarization of the battery cell generated during a formation process.

In the technical solution of this application, the target feature data related to polarization of the battery cell generated during the formation process of the battery cell is analyzed to determine whether the battery cell has experienced abnormal polarization. In this way, on the one hand, as there is a clear distinction in target feature data between a battery cell with abnormal polarization and a battery cell without abnormal polarization during a formation process, accurate determination of whether the battery cell has experienced abnormal polarization can be achieved, thereby achieving reliable identification of abnormal battery cells with abnormal polarization. On the other hand, since a formation process of a battery cell always occurs before the battery cell is loaded into a battery pack in an industrial production process, the purpose of identifying a battery cell with abnormal polarization before loading can also be achieved through the technical solution of the embodiments of this application, reducing the risk of decreased battery system performance caused by loading abnormal battery cells and the risk of battery pack scrapping caused by loading abnormal battery cells.

In some embodiments, the target feature data includes feature data reflecting a polarization difference of the battery cell collected during the formation process.

In the above technical solution, with the feature data reflecting the polarization difference of the battery cells collected during the formation process being used as the target feature data, differentiation between abnormal battery cells with abnormal polarization and normal battery cells without abnormal polarization can be achieved based on the target feature data, thereby achieving the effect of reliable identification of abnormal battery cells with abnormal polarization.

In some embodiments, the target feature data includes a maximum target parameter value collected in a first stage of the formation process and/or a polarization elimination deviation of a target parameter in the first stage of the formation process.

In practical applications, after extensive experiments, the inventors have found that the maximum parameter value and the polarization elimination deviation in the first stage of the formation process can be significantly different for a battery cell with abnormal polarization compared to a battery cell without abnormal polarization. Based on this, in the above technical solution, with the maximum target parameter value and/or polarization elimination deviation collected during the first stage of the formation process being used as the target feature data, the effect of reliable identification for abnormal battery cells with abnormal polarization can be achieved.

In some embodiments, the target feature data includes a target parameter value collected in a second stage of the formation process.

In practical application, after extensive experiments, the inventors have found that the parameter values in the second stage of the formation process have large differences between a battery cell with abnormal polarization and a battery cell without abnormal polarization. Based on this, in the above technical solution, with the target parameter value collected in the second stage of the formation process being used as the target feature data, the effect of reliable identification for abnormal battery cells with abnormal polarization can be achieved.

In some embodiments, the target parameter value collected in the second stage of the formation process includes a first target parameter value corresponding to the first arrival of a parameter variation at a first process variation threshold and a second target parameter value corresponding to the first arrival of the parameter variation at a second process variation, during a process of collecting parameters in the second stage; where the first process variation and the second process variation are different.

In practical applications, due to differences in characteristics between a battery cell with abnormal polarization and a battery cell without abnormal polarization, parameter values corresponding to an arrival at a given process variation during the second stage also differ. Based on this, in the above technical solution, the first target parameter value corresponding to the first arrival of the parameter variation at the first process variation threshold during the process of collecting parameters in the second stage, and the second target parameter value corresponding to the first arrival of the parameter variation at the second process variation during the process of collecting parameters in the second stage are used as the basis for determining whether the battery cell has experienced abnormal polarization, such that accurate identification for abnormal battery cells with abnormal polarization can be achieved by combining the two target parameter values, thereby improving the identification reliability.

In some embodiments, the determining, based on target feature data, whether the battery cell has experienced abnormal polarization includes: determining whether the battery cell has experienced abnormal polarization by determining whether there is a target parameter value in the second stage that is greater than a preset target parameter threshold; where under a condition that there is a target parameter value in the second stage that is greater than the preset target parameter threshold, it indicates that the battery cell has experienced abnormal polarization; otherwise, it indicates that the battery cell has not experienced abnormal polarization.

In practical application, after extensive experiments, the inventors have found that target parameter values of battery cells in the second stage are often greater than normal values due to the influence of abnormal polarization. Based on this, in the above technical solution, by the determination of whether there is a target parameter value in the second stage that is greater than a preset target parameter threshold, whether the battery cell has experienced abnormal polarization can be rapidly determined, thereby achieving rapid identification for abnormal battery cells with abnormal polarization.

In some embodiments, the determining, based on target feature data, whether the battery cell has experienced abnormal polarization includes: inputting the target feature data into a preset identification model to obtain an identification result of whether the battery cell has experienced abnormal polarization.

In the above technical solution, the preset identification model is used for processing the target feature data, such that the effect of quick identification for abnormal battery cells with abnormal polarization is achieved by using powerful recognition ability of the model.

In some embodiments, the identification model is a two-dimensional Gaussian model. The determining, based on target feature data, whether the battery cell has experienced abnormal polarization includes: inputting the target feature data into the two-dimensional Gaussian model to obtain a probability density of the battery cell calculated by the two-dimensional Gaussian model; and under a condition that the probability density of the battery cell is less than a preset probability density threshold, determining that the battery cell has experienced abnormal polarization.

The two-dimensional Gaussian model is a model that can well reflect the distribution of different types of data. In the above technical solution, the two-dimensional Gaussian model is used for identification to obtain the probability density of the battery cell, such that a rapid differentiation can be achieved between a battery cell with abnormal polarization and a battery cell without abnormal polarization based on the probability density of the battery cells and the preset probability density threshold.

In some embodiments, the determining, based on target feature data of a battery cell, whether the battery cell has experienced abnormal polarization includes: determining, during the formation process of the battery cell based on the target feature data of the battery cell, whether the battery cell has experienced abnormal polarization.

In the above technical solution, whether the battery cell has experienced abnormal polarization is determined based on the target feature data of the battery cell during the formation process of the battery cell, such that identification and screening of battery cells with abnormal polarization can be performed in the formation stage of the battery cells, achieving early identification for abnormal battery cells with abnormal polarization and avoiding the inclusion of abnormal battery cells in subsequent production processes, reducing waste of resources.

According to a second aspect, an embodiment of this application further provides an apparatus for identifying abnormal battery cell, including an identification module for determining, based on target feature data of a battery cell, whether the battery cell has experienced abnormal polarization; where the target feature data includes feature data related to polarization of the battery cell generated during a formation process.

In some embodiments, the target feature data includes feature data reflecting a polarization difference of the battery cell collected during the formation process.

In some embodiments, the target feature data includes a maximum target parameter value collected in a first stage of the formation process and/or a polarization elimination deviation of a target parameter in the first stage of the formation process.

In some embodiments, the target feature data includes a target parameter value collected in a second stage of the formation process.

In some embodiments, the target feature data includes a first target parameter value corresponding to the first arrival of a parameter variation at a first process variation threshold and a second target parameter value corresponding to the first arrival of the parameter variation at a second process variation, during a process of collecting parameters in the second stage; where the first process variation and the second process variation are different.

In some embodiments, the identification module is specifically configured to determine whether the battery cell has experienced abnormal polarization by determining whether there is a target parameter value in the second stage that is greater than a preset target parameter threshold. Under a condition that there is a target parameter value in the second stage that is greater than the preset target parameter threshold, it indicates that the battery cell has experienced abnormal polarization; otherwise, it indicates that the battery cell has not experienced abnormal polarization.

In some embodiments, the identification module is specifically configured to input the target feature data into a preset identification model to obtain an identification result of whether the battery cell has experienced abnormal polarization.

In some embodiments, the identification model is a two-dimensional Gaussian model; and the identification module is specifically configured to input the target feature data into the two-dimensional Gaussian model to obtain a probability density of the battery cell calculated by the two-dimensional Gaussian model; and under a condition that the probability density of the battery cell is less than a preset probability density threshold, determine that the battery cell has experienced abnormal polarization.

In some embodiments, the identification module is specifically configured to determine, during the formation process of the battery cell based on the target feature data of the battery cell, whether the battery cell has experienced abnormal polarization.

According to a third aspect, an embodiment of this application further provides an electronic device including a processor and a memory; where the processor is configured to execute one or more instructions stored in the memory to implement any one of the foregoing methods for identifying abnormal battery cell.

According to a fourth aspect, an embodiment of this application further provides a computer-readable storage medium, where the computer-readable storage medium stores one or more instructions, the instructions being executable by the processor to implement any one of the foregoing methods for identifying abnormal battery cell.

### BRIEF DESCRIPTION OF DRAWINGS

In order to describe the technical solutions in the embodiments of this application more clearly, the following briefly describes the accompanying drawings required for describing the embodiments of this application. It is appreciated that the accompanying drawings below only show some embodiments of this application and thus should not be considered as limitations on the scope. Persons of ordinary skill in the art may still derive other related drawings from the accompanying drawings without creative efforts.
FIG. 1 is a schematic structural diagram of a battery unit according to an embodiment of this application;
FIG. is 2 a schematic flowchart of a method for identifying abnormal battery cell according to an embodiment of this application; and
FIG. 3 is a schematic flowchart of a model construction method according to an embodiment of this application;
FIG. 4 is a specific schematic flowchart for achieving identification of abnormal battery cell according to an embodiment of this application;
FIG. 5 is a schematic diagram of an effect of a two-dimensional Gaussian model according to an embodiment of this application;
FIG. 6 is a schematic structural diagram of an apparatus for identifying abnormal battery cell according to an embodiment of this application;
FIG. 7 is a schematic structural diagram of a model construction apparatus according to an embodiment of this application; and
FIG. 8 is a schematic structural diagram of an electronic apparatus according to an embodiment of this application.

### DESCRIPTION OF EMBODIMENTS

The following describes in detail the embodiments of technical solutions of this application with reference to the accompanying drawings. The following embodiments are merely intended for a clearer description of the technical solutions of this application and therefore are used as just examples which do not constitute any limitations on the protection scope of this application.

Unless otherwise defined, all technical and scientific terms used herein shall have the same meanings as commonly understood by those skilled in the art to which this application relates. The terms used herein are intended to merely describe the specific embodiments rather than to limit this application. The terms "include", "comprise", and "have" and any other variations thereof in the specification, claims and brief description of drawings of this application are intended to cover non-exclusive inclusions.

In the description of the embodiments of this application, the terms "first", "second" and the like are merely intended to distinguish between different objects, and shall not be understood as any indication or implication of relative importance or any implicit indication of the number, sequence or primary-secondary relationship of the technical features indicated. In the description of embodiment of this application, "plurality" means more than two (including two), unless otherwise clearly and specifically limited.

In this specification, reference to "embodiment" means that specific features, structures or characteristics described with reference to the embodiment may be incorporated in at least one embodiment of this application. The word "embodiment" appearing in various places in the specification does not necessarily refer to the same embodiment or an independent or alternative embodiment that is exclusive of other embodiments. It is explicitly or implicitly understood by persons skilled in the art that the embodiments described herein may be combined with other embodiments.

In the description of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

In the description of the embodiments of this application, unless otherwise specified and defined explicitly, the terms "mount", "connect", "join", and "fasten" should be understood in their general senses. For example, they may refer to a fixed connection, a detachable connection, or an integral connection, may refer to a mechanical connection or electrical connection, and may refer to a direct connection, an indirect connection via an intermediate medium, or an interaction between two elements. Persons of ordinary skill in the art can understand specific meanings of these terms in this application as appropriate to specific situations.

Currently, from a perspective of the market development, application of electric vehicle batteries is becoming extensive. Electric vehicle batteries are widely used not only in energy storage power supply systems such as hydro, thermal, wind, and solar power plants, but also in electric transportation tools such as electric bicycles, electric motorcycles, and electric vehicles.

In these fields, the most commonly used electric vehicle batteries are lithium-ion batteries (batteries composed of lithium-ion battery cells). The inventors of the present invention have noticed that under a condition that a battery cell experiences abnormal polarization during production of lithium-ion batteries, although the battery cell does not show problems during the testing stage of the battery cell production line, the battery cell exhibits lithium precipitation and low capacity problems after use. Lithium precipitation of the battery cell may cause serious safety problems such as thermal runaway, while the low capacity of the battery cell seriously affects the effect and experience of using the battery cell. Therefore, loading of problematic battery cells with abnormal polarization affects performance of the battery system. Furthermore, as integration of battery systems increases, it is extremely difficult to remove battery cells. Therefore, once a problematic battery cell with abnormal polarization is loaded into a battery pack, even if the problematic battery cell is found later through technical means, it is difficult to remove the battery cell. Loading of the problematic battery cell can result in scrapping of an entire battery pack loaded with the abnormal battery cell. Therefore, it is necessary to identify battery cells with abnormal polarization before battery cell loading. Therefore, it is necessary to identify battery cells with abnormal polarization before the battery cells are loaded.

The inventors have further noted that formation of lithium-ion batteries is a key step in the production of batteries and that subsequent steps (including the step of battery cell loading) proceed only after the battery cells undergo formation. Process data (including but not limited to battery formation steps, time, current, voltage, temperature, and atmospheric pressure.) in the battery formation process is saved at the second and millisecond level. For battery cells with abnormal polarization and battery cells without abnormal polarization, values of some parameters differ during the formation process.

Based on the above considerations, to meet the demand for identifying battery cells with abnormal polarization before battery cell loading, the inventors have conducted in-depth research and designed a method for identifying abnormal battery cell, which involves obtaining target feature data related to polarization of a battery cell generated during a formation process and then determining, based on the target feature data, whether the battery cell has experienced abnormal polarization. In this way, on the one hand, as there is a clear distinction in target feature data between a battery cell with abnormal polarization and a battery cell without abnormal polarization during a formation process, accurate determination of whether the battery cell has experienced abnormal polarization can be achieved, thereby achieving reliable identification for abnormal battery cells with abnormal polarization. On the other hand, since a formation process of a battery cell always occurs before the battery cell is loaded into a battery pack in an industrial production process, the purpose of identifying a battery cell with abnormal polarization before the battery cell is loaded can also be effectively achieved, reducing the risk of decreased battery system performance caused by loading abnormal battery cells and the risk of battery pack scraping caused by loading abnormal battery cells.

To facilitate understanding of the embodiments of this application, some basic information related to the embodiments of this application is described below.

A battery pack is composed of a plurality of battery units. The battery unit is a smallest unit constituting a battery pack. There may be a plurality of battery units in one battery pack. The plurality of battery units may be connected in series, parallel, or series-parallel. Being connected in series-parallel means a combination of series and parallel connections of the plurality of battery units. The plurality of battery units may be directly connected in series, parallel, or series-parallel, and then an entirety of the plurality of battery units is accommodated in a box or other packaging, forming an entirety that can be charged and discharged externally.

In practical applications, a battery pack can be used as a single battery to provide services. However, a plurality of battery packs can also be connected in series, parallel, or series-parallel to form an entirety, and the entirety is accommodated in a box or other packaging to provide services as a battery. That is, in a battery, there can be one or more battery packs.

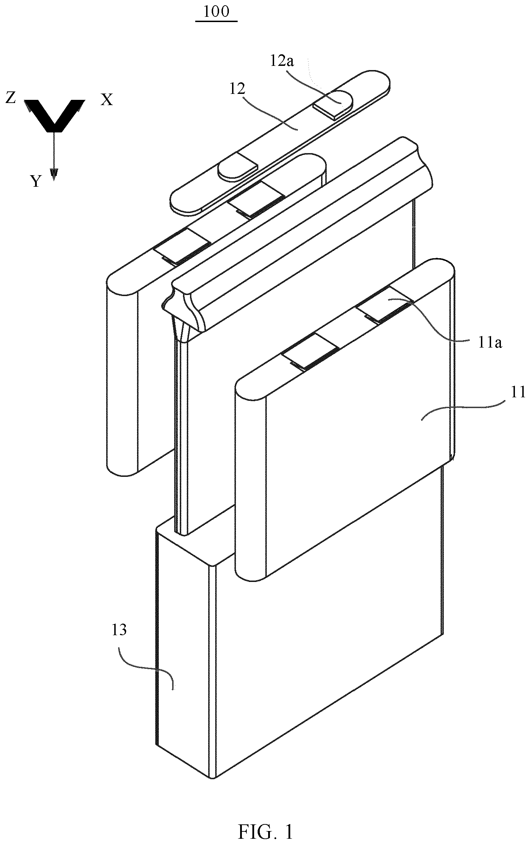

Referring to FIG. 1, a battery unit 100 can include a battery cell 11, an end cover 12, a housing 13, and other functional components.

The end cover 12 is a component that closes over an opening of the housing 13 to separate the internal environment of the battery unit 100 from the external environment. The shape of the end cover 12 is not limited and may be adapted to the shape of the housing 13 to fit the housing 13. Functional components such as an electrode terminal 12a may be provided on the end cover 12. The electrode terminal 12a may be electrically connected to the battery cell 11 for outputting or inputting electrical energy of the battery unit 100.

The housing 13 is an assembly configured to form the internal environment of the battery unit 100 together with the end cover 12, where the formed internal environment may be used to accommodate the battery cell 11, an electrolyte, and other components.

The battery cell 11 is a component in which electrochemical reactions take place in the battery unit 100. The housing 13 may include one or more battery cells 11. The battery cell 11 is mainly formed by winding or stacking a positive electrode plate and a negative electrode plate, and a separator is generally provided between the positive electrode plate and the negative electrode plate. Parts of the positive electrode plate and the negative electrode plate with active substances of the battery cell 11 constitute a body portion of the cell assembly, while parts of the positive electrode plate and the negative electrode plate without active substances separately constitute a tab 11a. A positive electrode tab and a negative electrode tab may both be located at one end of the body portion or be located at two ends of the body portion respectively. During charging and discharging of the battery, a positive electrode active substance and a negative electrode active substance react with an electrolyte, and the tabs 11a are connected to electrode terminals to form a current loop. When current passes through the battery cell, after the equilibrium state is broken, the actual electrode potential in the battery cell deviates from the equilibrium electrode potential, and this phenomenon is called polarization.

Each battery unit 100 may be a secondary battery or a primary battery. The battery unit 100 may be cylindrical, flat, cuboid, or of other shapes.

Formation of a lithium-ion battery refers to the process of activating the positive and negative electrode materials inside the battery cell by means of charging and discharging after the battery is manufactured, improving the self-discharge, charge-discharge performance, and storage performance of the battery.

In the embodiments of this application, the formation can be performed for battery cells that are not assembled into the battery unit 100, or for battery cells assembled into the battery unit 100.

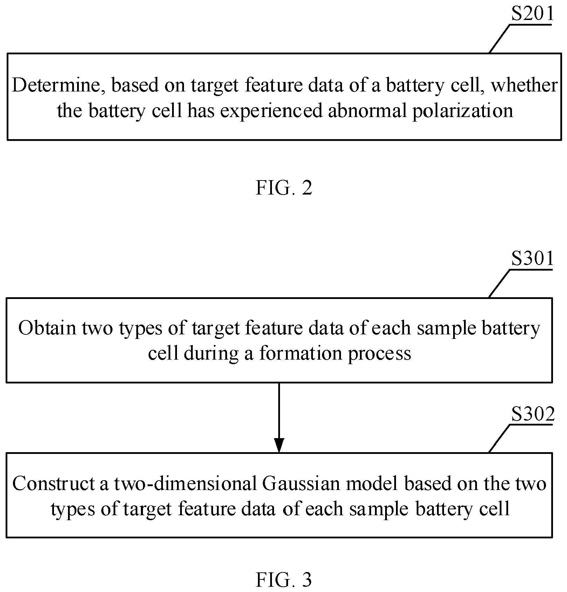

Based on the above introduction, according to some embodiments of this application, referring to FIG. 2, FIG. 2 shows a basic flowchart of a method for identifying abnormal battery cell according to an embodiment of this application, including the following steps.

S201. Determine, based on target feature data of a battery cell, whether the battery cell has experienced abnormal polarization.

It should be understood that, in some embodiments of this application, the target feature data is feature data related to polarization of the battery cell generated during a formation process. For example, the target feature data may be film-forming peak values (dQ/dV, where dQ is the amount of current flowing through the battery cell per unit time and dV is the voltage change per unit time in the battery cell), dynamic internal resistance (V/I, where V is the voltage and I is the current), dV/dQ, and other parameters generated during the formation process at a specific location.

In the embodiments of this application, during the formation process or after the completion of the formation process, formation process data (including but not limited to the steps of battery formation, time, current, voltage, temperature, atmospheric pressure, and other data) generated during the formation process of the battery cell can be imported into an electronic device that can perform the method for identifying abnormal battery cell provided in the embodiments of this application, so that the electronic device can obtain the target feature data of the battery cell from the formation process data.

In the embodiments of this application, under a condition that the target feature data of the battery cell is obtained during the formation process, whether the battery cell has experienced abnormal polarization can be determined based on the target feature data of the battery cell at the formation stage of the battery cell. In this way, battery cells with abnormal polarization can be identified and screened in the formation stage of the battery cells. This enables early identification of abnormal battery cells with abnormal polarization, avoiding the abnormal battery cells from entering subsequent production processes, thereby reducing the waste of resources.

It should be understood that values of parameters are constantly changing during the formation process. During the formation process, in some positions or intervals, values of parameters may be similar between problematic battery cells with abnormal polarization and normal battery cells without abnormal polarization. Therefore, differentiation is not effective based on the parameter values of these parameters in these positions or intervals. On the contrary, in some other positions or intervals, parameter values exhibit significant differences between the problematic battery cells with abnormal polarization and the normal battery cells without abnormal polarization, making it possible to effectively differentiate between problematic battery cells and normal battery cells. The parameter values in these given positions or intervals can be used as the target feature data in the embodiments of this application to achieve identification of whether the battery cell has experienced abnormal polarization.

For example, after extensive experiments, the inventors have found that maximum values of parameters and polarization elimination deviations in the first stage of the formation process exhibit significant differences between a battery cell with abnormal polarization and a battery cell without abnormal polarization. Therefore, in an optional implementation, the target feature data may include a maximum target parameter value collected in a first stage of the formation process and/or a polarization elimination deviation of a target parameter in the first stage of the formation process. In this way, with the maximum target parameter value and the polarization elimination deviation collected in the first stage of the formation process used as the target feature data, the effect of reliable identification of abnormal battery cells with abnormal polarization can be achieved.

It should be understood that in the embodiments of this application, the target parameter can be parameters that can reflect changes in the formation process and that are related to the polarization of the battery cells, such as film-forming peak, dynamic internal resistance, and dV/dQ. A target parameter value is a value of a target parameter. The maximum target parameter value is the maximum of all the target parameter values collected.

It should also be understood that the battery cell needs to be charged several times during the formation process, and the first stage in the embodiments of this application is a stage in which the first charging is performed in the formation process.

It should be noted that at the end of the first stage of the formation process, the value of the target parameter changes significantly, resulting in a "diving" phenomenon (that is, the target parameter value drops significantly in a very short time). In the embodiments of this application, the polarization elimination deviation of the target parameter is a variation of the target parameter during the "diving" phenomenon that occurs at the end of the first stage. For example, at the end of the first stage of the formation process, assuming that the film-forming peak changes significantly from A to B, then the polarization elimination deviation of film-forming peak is equal to B minus A.

For example, after extensive experiments, the inventors have also found that the values of the parameters in the second stage of the formation process are significantly different between a battery cell with abnormal polarization and a battery cell without abnormal polarization. Specifically, in a given period of time in the second stage of the formation process, parameter values of battery cells with abnormal polarization are significantly larger than parameter values of battery cells without abnormal polarization. Thus, in another optional implementation, the target feature data may include a target parameter value collected in a second stage of the formation process.

It should be understood that the second stage in the embodiments of this application is any charging stage other than the first stage during the formation process.

It is considered that in the second stage, the target parameter values are not always significantly different between a battery cell with abnormal polarization and a battery cell without abnormal polarization. Therefore, in the embodiments of this application, not all the target parameter values collected in the second stage of the formation process are used as the target feature data. Instead, only target parameter values at specified positions are used as the target feature data to reduce the amount of target feature data and improve identification efficiency. For example, a first target parameter value corresponding to the first arrival of a parameter variation at a first process variation threshold and a second target parameter value corresponding to the first arrival of the parameter variation at a second process variation, during a process of collecting parameters in the second stage may be used as the target feature data. The first process variation and the second process variation are different.

It should be noted that the process variation in the embodiments of this application is a variation of the target parameter within a specified collection time interval (such as a collection time interval between two adjacent collection points). For example, assuming that the target parameter is the film-forming peak, the process variation may be a film-forming peak gradient value.

It should be understood that there is a clear distinction in target feature data between a battery cell with abnormal polarization and a battery cell without abnormal polarization during a battery cell formation process. Therefore, whether a battery cell has experienced abnormal polarization can be accurately identified based on the target feature data, achieving reliable identification of battery cells with abnormal polarization.

To accurately determine whether the battery cell has experienced abnormal polarization, in an optional implementation of the embodiment of this application, a threshold can be specified based on differences in target feature data ranges between a battery cell with abnormal polarization and a battery cell without abnormal polarization as summarized in advance, to determine whether the battery cell has experienced abnormal polarization. (That is, whether the target feature data is greater than or less than the preset threshold is determined to determine whether the battery cell has experienced abnormal polarization based on a relationship between the target feature data and the threshold, summarized for battery cells with abnormal polarization and battery cells without abnormal polarization.)

For example, it is assumed that the target feature data includes the maximum target parameter value collected in the first stage of the formation process. Then, a target parameter threshold can be specified in advance so that the maximum target parameter value can be compared with this target parameter threshold. Under a condition that the comparison result matches the preset comparison result for battery cells with abnormal polarization, it is determined that the battery cell has experienced abnormal polarization. Otherwise, it is determined that the battery cell has not experienced abnormal polarization.

For another example, it is assumed that the target feature data includes the polarization elimination deviation of the target parameter collected in the first stage of the formation process. Then, a polarization elimination deviation threshold can be specified in advance to compare the polarization elimination deviation of the target parameter with this polarization elimination deviation threshold. Under a condition that the comparison result matches the preset comparison result for battery cells with abnormal polarization, it is determined that the battery cell has experienced abnormal polarization. Otherwise, it is determined that the battery cell has not experienced abnormal polarization.

For another example, it is assumed that the target feature data includes the maximum target parameter value collected in the first stage of the formation process and the polarization elimination deviation of the target parameter collected in the first stage of the formation process. Then a target parameter threshold and a polarization elimination deviation threshold can be specified in advance to compare the maximum target parameter value with the target parameter threshold and compare the polarization elimination deviation of the target parameter with the polarization elimination deviation threshold. Under a condition that the two comparison results respectively match comparison results for battery cells with abnormal polarization, it is determined that the battery cell has experienced abnormal polarization. Otherwise, it is determined that the battery cell has not experienced abnormal polarization.

For example, assuming that the target parameter is the film-forming peak, in the first stage of the formation process, under a condition that a maximum film-forming peak value is greater than the preset film-forming peak threshold, and a polarization elimination deviation of film-forming peak is less than the polarization elimination deviation threshold, it is determined that the battery cell has experienced abnormal polarization.

It should be understood that the target parameter threshold and the polarization elimination deviation threshold may be values specified based on the statistics of target parameter values and polarization elimination deviations in the first stage of the formation process performed in advance for a large number of first sample battery cells with abnormal polarization and a large number of second sample battery cells without abnormal polarization.

For another example, it is assumed that the target feature data includes a target parameter value collected in a second stage of the formation process. In a given period of time in the second stage of the formation process, parameter values of battery cells with abnormal polarization are significantly greater than parameter values of battery cells without abnormal polarization. Therefore, by the determination of whether there is a target parameter value in the second stage that is greater than the preset target parameter threshold, whether the battery cell has experienced abnormal polarization can be determined. Under a condition that there is a target parameter value in the second stage that is greater than the preset target parameter threshold, it indicates that the battery cell has experienced abnormal polarization; otherwise, it indicates that the battery cell has not experienced abnormal polarization.

For another example, it is assumed that the target feature data includes a first target parameter value corresponding to the first arrival of a parameter variation at a first process variation threshold and a second target parameter value corresponding to the first arrival of the parameter variation at a second process variation, during a process of collecting parameters in the second stage. Then, a first target parameter threshold may be specified corresponding to the first process variation threshold and a second target parameter threshold may be specified corresponding to the second process variation threshold, so that the first target parameter value is compared with the first target parameter threshold and the second target parameter value is compared with the second target parameter threshold. Under a condition that the two comparison results respectively match comparison results for battery cells with abnormal polarization, it is determined that the battery cell has experienced abnormal polarization. Otherwise, it is determined that the battery cell has not experienced abnormal polarization.

It should be understood that the preset target parameter threshold, the first target parameter threshold, and the second target parameter threshold in the above example can all be values specified in advance based on the statistics of the target parameter values in the second stage of the formation process for a large number of first sample battery cells with abnormal polarization and a large number of second sample battery cells without abnormal polarization.

To achieve an accurate determination of whether a battery cell has experienced abnormal polarization, in another optional implementation of the embodiment of this application, an identification model can be constructed to input the target feature data into the preset identification model, so as to obtain an identification result of whether the battery cell has experienced abnormal polarization.

The identification model may be a pre-constructed two-dimensional Gaussian model but is not limited thereto. For example, the identification model may alternatively be a classification model such as a SVM (Support Vector Machine, support vector machine) model or a CART (Classification And Regression Tree, classification and regression tree) model that takes the target feature data as input.

It should be noted that when a classification model such as the SVM (Support Vector Machine) model and the CART (Classification And Regression Tree) model is used for identification, each sample battery cell required for model construction needs to be pre-marked as a first sample battery cell with abnormal polarization or a second sample battery cell without abnormal polarization. Similarly, for the foregoing optional implementation of threshold-based identification, the sample battery cell used for setting the threshold also needs to be pre-marked as a first sample battery cell with abnormal polarization or a second sample battery cell without abnormal polarization. However, when the two-dimensional Gaussian model is used for identification, marking is not necessary and the two types of sample battery cells can be differentiated by the clustering ability of the two-dimensional Gaussian model itself. Therefore, when the two-dimensional Gaussian model is used for identification, the workload of engineers can be reduced, and the difficulty of obtaining data corresponding to sample battery cells can be reduced.

It should also be noted that when the identification model is a two-dimensional Gaussian model, there should be two kinds of target feature data to meet the data input requirements of the two-dimensional Gaussian model. For example, the target feature data can be a maximum target parameter value collected in a first stage of the formation process and a polarization elimination deviation of a target parameter in the first stage of the formation process. For another example, the target feature data can be a first target parameter value corresponding to the first arrival of a parameter variation at a first process variation threshold and a second target parameter value corresponding to the first arrival of the parameter variation at a second process variation, during a process of collecting parameters in the second stage.

The following uses a two-dimensional Gaussian model as an identification model example to further describe the solution of the embodiments of this application.

To ensure that accurate determination of whether a battery cell has experienced abnormal polarization can be achieved based on the two-dimensional Gaussian model, it is necessary to first select two types of target feature data and then construct an appropriate two-dimensional Gaussian model based on the two types of target feature data.

Referring to FIG. 3, FIG. 3 illustrates a model construction method provided in an embodiment of this application, including the following steps.

S301.Obtain two types of target feature data of each sample battery cell during a formation process.

It should be noted that the sample battery cells include a first sample battery cell with abnormal polarization and a second sample battery cell without abnormal polarization.

The two types of target feature data of the first sample battery cell and the second sample battery cell can be collected from the production line or other channels.

S302. Construct a two-dimensional Gaussian model based on the two types of target feature data of each sample battery cell.

In the embodiments of this application, the mean value and variance of the two types of target feature data can be calculated, and the correlation coefficient between the two types of target feature data can be calculated. Based on the mean value and variance of the two types of target feature data and the correlation coefficient between features, the mean vector and the covariance matrix that are necessary for the two-dimensional Gaussian model can be constructed. Then, based on the mean vector and covariance matrix, the two-dimensional Gaussian model can be obtained.

There may be some abnormal data in the two types of target feature data of the sample battery cells obtained, which may affect the reliability of the constructed two-dimensional Gaussian model. Therefore, in a feasible implementation of the embodiment of this application, a preliminary two-dimensional Gaussian model may first be constructed based on the two types of target feature data of all sample battery cells. Then, a final two-dimensional Gaussian model is constructed based on two types of target feature data of each sample battery cell belonging to a target cluster in the preliminary two-dimensional Gaussian model. The target cluster is a cluster represented by second sample battery cells without abnormal polarization in the preliminary two-dimensional Gaussian model.

It should be understood that the construction methods of the two two-dimensional Gaussian models are described in the preceding paragraph and are not repeated herein.

It should be understood that in the embodiments of this application, after the two-dimensional Gaussian model is constructed based on the two types of target feature data of the first sample battery cell and the second sample battery cell, the probability density distribution belonging to the second sample battery cell is obtained in the two-dimensional Gaussian model, and based on this distribution, a probability density threshold can be set.

Therefore, in a situation where the two-dimensional Gaussian model is used to determine whether the battery cell has experienced abnormal polarization, after the two types of target feature data of the battery cell are input to the two-dimensional Gaussian model, a corresponding probability density of the battery cell can be obtained. Then, this probability density can be compared with the specified probability density threshold. Under a condition that the probability density is less than the probability density threshold, it can be determined that the battery cell has experienced abnormal polarization. Otherwise, it can be determined that the battery cell has not experienced abnormal polarization.

It should be noted that the two types of target feature data used in constructing the two-dimensional Gaussian model should be consistent with the target feature data of the battery cells collected in the subsequent abnormal battery cell identification process. That is, under a condition that the two types of target feature data used in constructing the two-dimensional Gaussian model are: a maximum target parameter value collected in a first stage of a formation process and a polarization elimination deviation of a target parameter collected in the first stage of the formation process, the target feature data of the battery cell collected in abnormal battery cell identification should also be: the maximum target parameter value collected in the first stage of the formation process and the polarization elimination deviation of the target parameter in the first stage of the formation process. Under a condition that the two types of target feature data used in constructing the two-dimensional Gaussian model are: a first target parameter value corresponding to the first arrival of a parameter variation at a first process variation threshold and a second target parameter value corresponding to the first arrival of the parameter variation at a second process variation, during a process of collecting parameters in the second stage, then the target feature data of the battery cell collected for identifying abnormal battery cell should also be: the first target parameter value corresponding to the first arrival of the parameter variation at the first process variation threshold during the process of collecting parameters and the second target parameter value corresponding to the first arrival of the parameter variation at the second process variation during the process of collecting parameters in the second stage.

It should also be noted that under a condition that the two types of target feature data are the first target parameter value corresponding to the first arrival of the parameter variation at the first process variation threshold during the process of collecting parameters in the second stage, and the second target parameter value corresponding to the first arrival of the parameter variation at the second process variation during the process of collecting parameters in the second stage, to ensure the differentiation effect of the target feature data for battery cells with abnormal polarization and battery cells without abnormal polarization, the selected first process variation and the second process variation can be two process variations that have the maximum discriminability between the first sample battery cell and the second sample battery cell.

Therefore, to accurately find out the two process variations that have the maximum discriminability between the first sample battery cell and the second sample battery cell, in the embodiments of this application, target parameter values corresponding to different preset process variations reached by all sample battery cells during the formation process can be obtained, and then the first process variation and the second process variation can be identified based on the target parameter values corresponding to the different process variations.

For example, based on the target parameter values corresponding to the two different process variations, the discriminability between the first sample battery cell and the second sample battery cell corresponding to the two different process variations can be calculated, and then the two different process variations corresponding to the maximum discriminability can be determined as the first process variation and the second process variation.

It should be understood that in the embodiments of this application, the LDA (Linear Discriminant Analysis, linear discriminant analysis) algorithm can be used to calculate the discriminability between the first sample battery cell and the second sample battery cell corresponding to each two different process variations of all the different process variations (for example, the inter-class distance calculated by the LDA algorithm).

For example, it is assumed that there are three different process variations, A, B, and C, the discriminability ab between A and B, the discriminability ac between A and C, and the discriminability be between B and C can be calculated using the LDA algorithm. Then, a maximum value can be determined from ab, ac, and bc. Assuming that the maximum value is ac, it can be determined that the first process variation and the second process variation are A and C, respectively.

In the embodiments of this application, to ensure the identification effect for the first process variation and the second process variation, the target parameter value corresponding to each process variation can be further normalized before the LDA algorithm is used for calculation, so that the target parameter value corresponding to each process variation is transformed into a standard normal distribution obeying N(0, 1), thus facilitating the processing of the LDA algorithm.

It should be understood that another type of identification model can be trained based on the target feature data to obtain a trained identification model, which can then be used. The training process is consistent with the conventional training process for various types of identification models and therefore is not described in detail herein.

In the embodiments of this application, under a condition that a battery cell is determined to have experienced abnormal polarization, the battery cell can be marked for subsequent processing and analysis by engineers based on the mark. For example, after identifying all abnormal battery cells in one or several batches, the quantity of battery cells with abnormal polarization can be counted based on the mark. If the counted quantity of battery cells with abnormal polarization is greater than a preset quantity threshold, it can be suspected that there are problems such as stains on the production line, which cause battery cell contamination and abnormal polarization, and alarm operations can be performed accordingly.

It should be noted that the above solution of the embodiment of this application can be realized by an electronic device with data processing capabilities, such as a PLC (Programmable Logic Controller, programmable logic controller), a computer, a smartphone, and a server.

It should be understood that in the embodiments of this application, the electronic device can be connected to the Industrial Internet so that the marked battery cells are notified to the Industrial Internet, and then to engineers by the Industrial Internet.

In the technical solution of the embodiment of this application, whether a battery cell has experienced abnormal polarization can be accurately determined by analyzing the target feature data related to battery cell polarization generated during the battery cell formation process. In this way, on the one hand, as there is a clear distinction in target feature data between a battery cell with abnormal polarization and a battery cell without abnormal polarization during a formation process, accurate determination of whether the battery cell has experienced abnormal polarization can be achieved, thereby achieving reliable identification of abnormal battery cells with abnormal polarization. On the other hand, since a formation process of a battery cell always occurs before the battery cell is loaded into a battery pack in an industrial production process, the purpose of identifying a battery cell with abnormal polarization before loading can also be effectively achieved through the technical solution of the embodiments of this application, reducing the risk of decreased battery system performance caused by loading abnormal battery cells and the risk of battery pack scrapping caused by loading abnormal battery cells.

To facilitate understanding of the solution provided in the embodiments of this application, the following uses an example of a specific implementation process to further describe this application. In the example, an execution body is a PLC; target feature data is a maximum film-forming peak value collected in a first stage of a formation process and a polarization elimination deviation of film-forming peak in the first stage of the formation process; and a two-dimensional Gaussian model is used for identification.

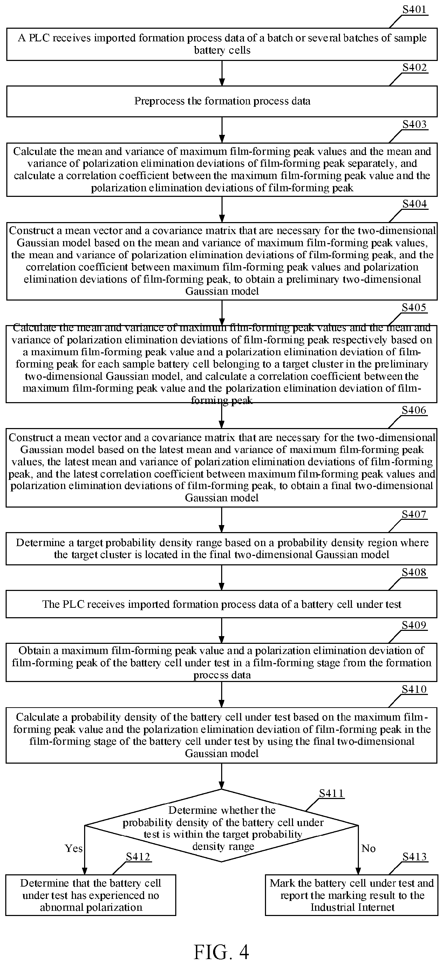

Referring to FIG. 4, the implementation process includes the following steps.

S401. APLC receives imported formation process data of a batch or several batches of sample battery cells.

The data can be imported according to formation batches or according to battery cells that complete formation each day. According to the law of large numbers, as the amount of data increases, the statistical parameters increasingly align with the normal data distribution pattern of battery cells. The batch of battery cells may include the first sample battery cells with abnormal polarization and the second sample battery cells without abnormal polarization.

It should be noted that the formation process data is process data (including but not limited to battery formation steps, time, current, voltage, temperature, and atmospheric pressure) saved during the formation process of the battery cells.

S402. Preprocess the formation process data.

This step includes: removing formation process data corresponding to battery cells that have experienced formation termination, abnormal sampling of the formation device, non-participation in formation, first-stage interruption, formation retesting, and the like, and obtaining film-forming peak data (including film-forming peak values) from the remaining formation process data to obtain a maximum film-forming peak value collected in the first stage of the formation process for each battery cell and a polarization elimination deviation of film-forming peak in the first stage of the formation process.

Under a condition that the number of formation steps in formation process data of a sample battery cell is less than a specified number of formation steps, it is determined that the sample battery cell has experienced formation termination; under a condition that there is data corruption in formation process data of a sample battery cell, it is determined that the sample battery cell has experienced abnormal sampling by a formation device; under a condition that formation process data of a sample battery cell includes no current value and shows that the voltage value does not increase, it is determined that the sample battery cell has not participated in formation; under a condition that formation process data of a sample battery cell shows that charging is terminated and resumed in a first stage, it is determined that the sample battery cell has experienced first-stage interruption; and under a condition that the number of formation steps in formation process data of a sample battery cell is greater than a specified number of formation steps, it is determined that the sample battery cell has experienced formation retesting.

It should be noted that the film-forming peak value can be calculated based on the current, voltage, and other data in the formation process data. After a film-forming peak value corresponding to each sampling point in the first stage of the formation process is obtained, the largest one is selected from them to be the maximum film-forming peak value. In addition, a polarization elimination deviation of a film-forming peak can be obtained by calculating a difference between film-forming peak values observed at two ends when the polarization elimination phenomenon occurs at the end of the first stage of the formation process.

S403. Calculate the mean and variance of maximum film-forming peak values and the mean and variance of polarization elimination deviations of film-forming peak separately, and calculate a correlation coefficient between the maximum film-forming peak value and the polarization elimination deviation of film-forming peak.

S404. Construct a mean vector and a covariance matrix that are necessary for a two-dimensional Gaussian model based on the mean and variance of maximum film-forming peak values, the mean and variance of polarization elimination deviations of film-forming peak, and the correlation coefficient between maximum film-forming peak values and polarization elimination deviations of film-forming peak, to obtain a preliminary two-dimensional Gaussian model.

S405. Calculate the mean and variance of maximum film-forming peak values and the mean and variance of polarization elimination deviations of film-forming peak respectively based on a maximum film-forming peak value and a polarization elimination deviation of film-forming peak of each sample battery cell belonging to a target cluster in the preliminary two-dimensional Gaussian model, and calculate a correlation coefficient between the maximum film-forming peak value and the polarization elimination deviation of film-forming peak.

It should be understood that the target cluster is a cluster of second sample battery cells without abnormal polarization in the preliminary two-dimensional Gaussian model.

S406. Construct a mean vector and a covariance matrix that are necessary for the two-dimensional Gaussian model based on the latest mean and variance of maximum film-forming peak values, the latest mean and variance of polarization elimination deviations of film-forming peak, and the latest correlation coefficient between maximum film-forming peak values and polarization elimination deviations of film-forming peak, to obtain a final two-dimensional Gaussian model.

S407. Determine a target probability density range based on a probability density region where the target cluster is located in the final two-dimensional Gaussian model.

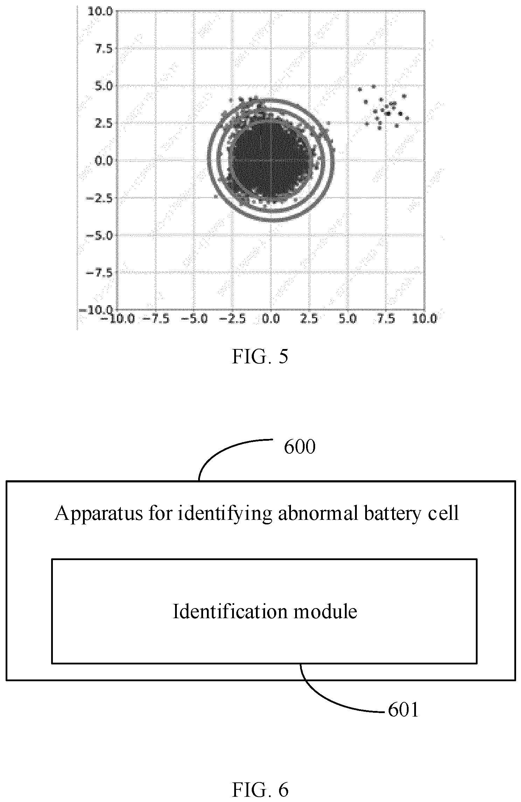

For example, as shown in FIG. 5, a region delineated by three circles in FIG.5 is a region where the target cluster is located. Engineers can take a probability density range corresponding to sample battery cells within a range delineated by any circle as the target probability density range. For example, a probability density range corresponding to sample battery cells in a region delineated by the outermost circle can be taken as the target probability density range. It should be understood that the horizontal coordinate in FIG. 5 is the maximum film-forming peak value and the vertical coordinate is the polarization elimination deviation of film-forming peak.

S408. The PLC receives imported formation process data of a battery cell under test.

S409. Obtain a maximum film-forming peak value and a polarization elimination deviation of film-forming peak of the battery cell under test in a first stage from the formation process data.

S410. Calculate a probability density of the battery cell under test based on the maximum film-forming peak value and the polarization elimination deviation of film-forming peak in the first stage of the battery cell under test by using the final two-dimensional Gaussian model.

S411. Determine whether the probability density of the battery cell under test is within the target probability density range; if yes, go to step S412; or if no, go to step S413.

For example, the target probability density range may be a range starting with 0. In this condition, only one probability density threshold can be specified to determine whether the probability density of the battery cell under test is less than the probability density threshold. If yes, indicating that the probability density of the battery cell under test is within the target probability density range, go to step S412; if no, go to step S413.

S412. Determine that the battery cell under test has not experienced abnormal polarization.

S413. Mark the battery cell under test and report the marking result to the Industrial Internet.

It should be understood that in the embodiments of this application, instead of making determination based on the probability density, an alternative approach is to convert the battery cell under test into a coordinate point in the coordinate system shown in FIG. 5 by taking the maximum film-forming peak value and the polarization elimination deviation of film-forming peak of the battery cell under test in the first stage as two coordinate values of a coordinate point, to determine whether the coordinate point lies within a specified circle (for example, the outermost circle in FIG. 5). If yes, it is determined that the battery cell under test has not experienced abnormal polarization; if no, it is determined that the battery cell under test has experienced abnormal polarization. Then, the battery cell under test can be marked and the marking result can be reported to the Industrial Internet.

It should also be understood that the process shown in FIG. 4 essentially consists of two stages, where step S401 to step S407 are a model construction stage and step S408 to step S413 are a battery cell identification stage. After the final two-dimensional Gaussian model is constructed through steps S401 to S407, the final two-dimensional Gaussian model can be repeatedly applied, that is, steps S408 to S413 can be repeatedly performed for different battery cells under test.

In the above way, the purpose of identifying battery cells with abnormal polarization before the battery cells are loaded can be achieved. In addition, experimental tests show that this method has strong robustness and a low false detection rate and can have good effects in practical applications.

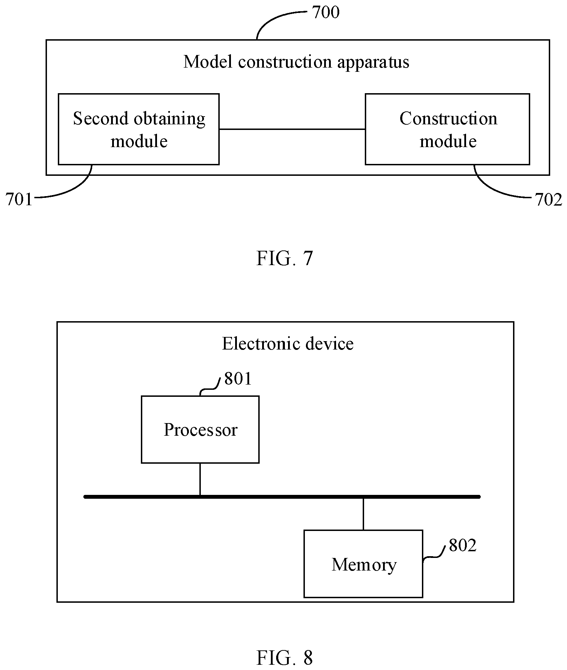

Based on the same inventive idea, an embodiment of this application further provides an apparatus 600 for identifying abnormal battery cell and a model construction apparatus 700. Referring to FIG. 6 and FIG. 7, FIG. 6 shows an apparatus for identifying abnormal battery cell using the method shown in FIG. 2, and FIG. 7 shows a model construction apparatus using the method shown in FIG. 3. It should be understood that specific functions of the apparatus 600 and apparatus 700 can be found in the description above, and a detailed description is appropriately omitted herein to avoid repetition. The apparatus 600 and apparatus 700 include at least one software function module capable of being stored in memory in the form of software or being embedded in the operating system of the apparatus 600 and apparatus 700 in the form of firmware. Details are as follows.

Referring to FIG. 6, the apparatus 600 includes:
an identification module 601 for determining, based on target feature data of a battery cell, whether the battery cell has experienced abnormal polarization; where the target feature data includes feature data related to polarization of the battery cell generated during a formation process.

In an optional embodiment of the embodiments of this application, the target feature data includes feature data reflecting a polarization difference of the battery cell collected during the formation process.

In an example implementation of the foregoing optional embodiment, the target feature data includes a maximum target parameter value collected in a first stage of the formation process and a polarization elimination deviation of a target parameter in the first stage of the formation process.

In another example implementation of the foregoing optional embodiment, the target feature data includes a target parameter value collected in a second stage of the formation process.

In the another example implementation, the target feature data includes a first target parameter value corresponding to the first arrival of a parameter variation at a first process variation threshold and a second target parameter value corresponding to the first arrival of the parameter variation at a second process variation, during a process of collecting parameters in the second stage; where the first process variation and the second process variation are different.

In an embodiment of this application, the identification module 601 is specifically configured to determine whether the battery cell has experienced abnormal polarization by determining whether there is a target parameter value in the second stage that is greater than a preset target parameter threshold; where under a condition that there is a target parameter value in the second stage that is greater than the preset target parameter threshold, it indicates that the battery cell has experienced abnormal polarization; otherwise, it indicates that the battery cell has not experienced abnormal polarization.

In the embodiments of this application, the identification module 601 is specifically configured to input the target feature data into a preset identification model to obtain an identification result of whether the battery cell has experienced abnormal polarization.

In an embodiment of this application, the identification model is a two-dimensional Gaussian model; and the identification module 601 is specifically configured to input the target feature data into the two-dimensional Gaussian model to obtain a probability density of the battery cell calculated by the two-dimensional Gaussian model; and under a condition that the probability density of the battery cell is less than a preset probability density threshold, determine that the battery cell has experienced abnormal polarization.

In an embodiment of this application, the identification module 601 is specifically configured to determine, during the formation process of the battery cell based on the target feature data of the battery cell, whether the battery cell has experienced abnormal polarization.

In an embodiment of this application, the apparatus 600 further includes a marking module for marking a battery cell with abnormal polarization.

Referring to FIG. 7, the apparatus 700 includes:
a second obtaining module 701 configured to obtain two types of target feature data of each sample battery cell during a formation process; where the target feature data includes feature data related to polarization of the battery cell generated during a formation process, and the sample battery cells include a first sample battery cell with abnormal polarization and a second sample battery cell without abnormal polarization; and
a construction module 702 for constructing a two-dimensional Gaussian model based on the two types of target feature data of each sample battery cell.

In an embodiment of this application, the construction module 702 is specifically configured to construct a preliminary two-dimensional Gaussian model based on the two types of target feature data of each sample battery cell and construct a final two-dimensional Gaussian model based on two types of target feature data of each sample battery cell belonging to a target cluster in the preliminary two-dimensional Gaussian model, where the target cluster is a cluster of second sample battery cells without abnormal polarization in the preliminary two-dimensional Gaussian model.

In an optional implementation of an embodiment of this application, the two types of target feature data include a maximum target parameter value collected in a first stage of a formation process and a polarization elimination deviation of a target parameter collected in the first stage of the formation process.

It should be understood that, for the sake of brevity, descriptions in the foregoing method section are not repeated in the apparatus section.

An embodiment of this application further provides an electronic device. Referring to FIG. 8, the electronic device includes a processor 801 and a memory 802.

The processor 801 is configured to execute one or more instructions stored in the memory 802 to implement the foregoing method for identifying abnormal battery cell or to implement the model construction method described above.

It should be noted that the processor 801 and the memory 802 can be connected via, but not limited to, an internal communication bus.

It should be understood that the structure shown in FIG. 8 is for illustration only, and the electronic device may include more or fewer components than shown in FIG. 8 or may have a different configuration from that shown in FIG. 8. For example, the electronic device may further have a data input interface, a data output interface, and other components.

In an embodiment of this application, the electronic device may be a PLC, a computer, a smartphone, a server, and other devices with data processing capabilities, without limitation in the embodiments of this application.

It should be noted that the PLC is a digital computing controller with a microprocessor, configured for automation control. The PLC can load at any time control instructions to the memory for storage for execution. The PLC consists of functional units such as a microprocessor, a memory, an input/output interface, and power supply. When the electronic device is a PLC, the processor 801 is a microprocessor of the PLC, and the memory 802 is a memory of the PLC.

An embodiment of this application further provides a computer-readable storage medium, such as a floppy disk, an optical disk, a hard drive, a flash memory, a USB drive, an SD (Secure Digital Memory Card, secure digital memory card) card, and an MMC (Multimedia Card, multimedia card) card. The computer-readable storage medium stores one or more instructions for implementing the various steps described above. These one or more instructions can be executed by one or more processors to implement the method for identifying battery cell or the model construction method described above. This is not repeated herein.

In conclusion, it should be noted that the foregoing embodiments are for description of the technical solutions of this application only rather than for limiting this application. Although this application has been described in detail with reference to the foregoing embodiments, persons of ordinary skill in the art should appreciate that they can still make modifications to the technical solutions described in the embodiments or make equivalent replacements to some or all technical features thereof without departing from the scope of the technical solutions of the embodiments of this application. All such modifications and equivalent replacements shall fall within the scope of claims and specification of this application. In particular, as long as there is no structure or step conflict, the various technical features mentioned in the embodiments can be combined in any manner. This application is not limited to the specific embodiments disclosed in this specification but includes all technical solutions falling within the scope of the claims.

## Claims

1. A method for identifying abnormal battery cell, **characterized by**:
determining, based on target feature data of a battery cell, whether the battery cell has experienced abnormal polarization, wherein
the target feature data comprises feature data related to polarization of the battery cell generated during a formation process.

2. The method for identifying abnormal battery cell according to claim 1, wherein the target feature data comprises feature data reflecting a polarization difference of the battery cell collected during the formation process.

3. The method for identifying abnormal battery cell according to claim 2, wherein the target feature data comprises:
a maximum target parameter value collected in a first stage of the formation process and/or a polarization elimination deviation of a target parameter in the first stage of the formation process.

4. The method for identifying abnormal battery cell according to claim 2, wherein the target feature data comprises:
a target parameter value collected in a second stage of the formation process.

5. The method for identifying abnormal battery cell according to claim 4, wherein the target parameter value collected in the second stage of the formation process comprises:
a first target parameter value corresponding to first arrival of a parameter variation at a first process variation threshold and a second target parameter value corresponding to first arrival of the parameter variation at a second process variation, during a process of collecting parameters in the second stage, wherein the first process variation and the second process variation are different.

6. The method for identifying abnormal battery cell according to claim 4, wherein the determining, based on target feature data, whether the battery cell has experienced abnormal polarization comprises:
determining whether the battery cell has experienced abnormal polarization by determining whether there is a target parameter value in the second stage that is greater than a preset target parameter threshold, wherein
under a condition that there is a target parameter value in the second stage that is greater than the preset target parameter threshold, it indicates that the battery cell has experienced abnormal polarization; otherwise, it indicates that the battery cell has not experienced abnormal polarization.

7. The method for identifying abnormal battery cell according to any one of claims 1 to 5, wherein the determining, based on target feature data, whether the battery cell has experienced abnormal polarization comprises:
inputting the target feature data into a preset identification model to obtain an identification result of whether the battery cell has experienced abnormal polarization.

8. The method for identifying abnormal battery cell according to claim 6, wherein the identification model is a two-dimensional Gaussian model; and
the determining, based on target feature data, whether the battery cell has experienced abnormal polarization comprises:
inputting the target feature data into the two-dimensional Gaussian model to obtain a probability density of the battery cell calculated by the two-dimensional Gaussian model; and
under a condition that the probability density of the battery cell is less than a preset probability density threshold, determining that the battery cell has experienced abnormal polarization.

9. The method for identifying abnormal battery cell according to any one of claims 1 to 6, wherein the determining, based on target feature data of a battery cell, whether the battery cell has experienced abnormal polarization comprises:
determining, during the formation process of the battery cell and based on the target feature data of the battery cell, whether the battery cell has experienced abnormal polarization.

10. An apparatus for identifying abnormal battery cell, **characterized by**:
an identification module for determining, based on target feature data of a battery cell, whether the battery cell has experienced abnormal polarization, wherein
the target feature data comprises feature data related to polarization of the battery cell generated during a formation process.

11. An electronic device, comprising a processor and a memory, wherein
the processor is configured to execute one or more instructions stored in the memory to implement the method for identifying abnormal battery cell according to any one of claims 1 to 9.

12. A computer-readable storage medium, wherein the computer-readable storage medium stores one or more instructions, the instructions being executable by the processor to implement the method for identifying abnormal battery cell according to any one of claims 1 to 9.
